# EUROPEAN PATENT APPLICATION

(11) **EP 4 687 316 A1**
(43) Date of publication of application: **04.02.2026**
(21) Application number: 24795473.8
(22) Date of filing: 23.01.2024
(51) Int. Cl.: H04L 1/00, H04B 10/25, H04B 10/2575

(54) **COMMUNICATION METHOD, COMMUNICATION DEVICE, AND STORAGE MEDIUM**

(30) Priority: 26.04.2023 CN 202310476660
(71) Applicant: ZTE Corporation, Shenzhen, Guangdong 518057 (CN)
(72) Inventor: ZHANG, Weiliang, Shenzhen, Guangdong 518057 (CN); HUANG, Xingang, Shenzhen, Guangdong 518057 (CN)
(74) Representative: Aipex B.V.
(86) International application number: PCT/CN2024/073665
(87) International publication number: WO 2024/222084

(57) **Abstract**

Provided are a communication method, a communication device, and a storage medium. The communication method applied to the first communication device includes performing, based on code type indication information, FEC decoding on part or all of associated downstream slots using an FEC code type corresponding to the code type indication information (S110), where the code type indication information is received from a second communication device and is used to indicate an FEC code type used in at least one of the associated downstream slots.

## Description

### TECHNICAL FIELD

The present application relates to the field of communication technology, for example, a communication method, a communication device, and a storage medium.

### BACKGROUND

In a passive optical network (PON) system, an optical line terminal (OLT) connects to one or more optical network units (ONUs) through an optical distribution network (ODN). In the PON system, the downstream is inherently broadcast, meaning that data frames sent by the OLT can be received by all ONUs, and each ONU performs filtering on the received data frames based on identifiers such as an ONU identity or a link identifier, whereas the upstream is transmitted by employing time division multiple access (TDMA), meaning that ONUs transmit burst data frames within an upstream bandwidth allocated by the OLT. To improve the accuracy of data transmission, a sender in the PON system typically applies forward error correction (FEC) encoding to data frames, that is, inserting parity information into the data frame part to form FEC code blocks; and a receiver decodes the data frames and performs FEC decoding on the FEC code blocks in the data frames based on the parity information to correct bits that have errors occurred during transmission. In the Higher Speed Passive Optical Networks (HSP) system defined by the International Telecommunication Union Telecommunication Standardization Sector (ITU-T) G.9804.2 standard, different FEC code types can be flexibly selected for the upstream based on different link conditions. Generally, the HSP system defaults to the Default (DE) code type. When link quality is good, the High Throughput (HT) code type can be used to achieve better bandwidth efficiency. When link quality is poor, the High Margin (HM) code type can be used to provide enhanced error correction capability. In the HSP system, the upstream is transmitted in a burst transmission mode, meaning that each burst data frame is sent by a single ONU, and if the FEC code types are switched based on link qualities, it is relatively straightforward to implement because it can be performed per burst data frame or based on the bandwidth allocation corresponding to the ONU. However, in the HSP system, the downstream is transmitted in a continuous transmission mode, and if the FEC code types are switched based on link qualities, it is relatively difficult to implement because ONUs, when receiving downstream data frames, need to distinguish their own data and information while also need to identify the switching of the types of FEC encoding, and no FEC code type switching mechanism for the downstream is yet defined in the HSP system.

### SUMMARY

In view of the above, embodiments of the present application provide a communication method, a communication device, and a storage medium to achieve flexible switching of FEC code types in the downstream.

An embodiment of the present application provides a communication method applied to a first communication device. The communication method includes the following:

Based on code type indication information, FEC decoding is performed on part or all of associated downstream slots using an FEC code type corresponding to the code type indication information, where the code type indication information is received from a second communication device and is used to indicate an FEC code type used in at least one of the associated downstream slots.

An embodiment of the present application provides a communication method. The communication method is applied to a second communication device. The communication method includes the following:

At least one FEC code type corresponding to at least one FEC code block in at least one associated slot is determined. Based on part or all of the at least one associated slot and the at least one FEC code type, code type indication information is generated, where the code type indication information is used to indicate an FEC code type used in at least one associated downstream slot. In an associated slot among the at least one associated slot, an FEC code block is generated using a respective FEC code type among the at least one FEC code type. The code type indication information and the generated FEC code block are sent to a first communication device.

An embodiment of the present application provides a communication apparatus applied to a first communication device. The communication apparatus includes a decoder.

The decoder is configured to perform, based on code type indication information, FEC decoding on part or all of associated downstream slots using an FEC code type corresponding to the code type indication information, where the code type indication information is received from a second communication device and is used to indicate an FEC code type used in at least one of the associated downstream slots.

An embodiment of the present application provides a communication apparatus applied to a second communication device. The communication apparatus includes a determination module, a first generator, a second generator, and a sender.

The determination module is configured to determine at least one FEC code type corresponding to at least one FEC code block in at least one associated slot. The first generator is configured to generate, based on part or all of the at least one associated slot and the at least one FEC code type, code type indication information, where the code type indication information is used to indicate an FEC code type used in at least one associated downstream slot. The second generator is configured to generate, in an associated slot among the at least one associated slot, an FEC code block using a respective FEC code type among the at least one FEC code type. The sender is configured to send the code type indication information and the generated FEC code block to a first communication device.

An embodiment of the present application provides a communication device. The communication device includes a memory and one or more processors. The memory is configured to store one or more programs. The one or more programs, when executed by the one or more processors, cause the one or more processors to implement the communication method according to any of the embodiments described above.

An embodiment of the present application provides a storage medium. The storage medium stores a computer program that, when executed by a processor, implements the communication method according to any of the embodiments described above.

### BRIEF DESCRIPTION OF DRAWINGS

FIG. 1 is a diagram illustrating a configuration of a downstream protocol frame according to an embodiment of the present application.
FIG. 2 is a diagram illustrating a configuration of a downstream synchronization block according to an embodiment of the present application.
FIG. 3 is a diagram illustrating the structure of a downstream physical frame according to an embodiment of the present application.
FIG. 4 is a flowchart of a communication method according to an embodiment of the present application.
FIG. 5 is a flowchart of another communication method according to an embodiment of the present application.
FIG. 6 is a diagram illustrating an implementation of downstream slot mapping partition according to an embodiment of the present application.
FIG. 7 is a diagram illustrating a configuration of code type indication information according to an embodiment of the present application.
FIG. 8 is a diagram illustrating another configuration of code type indication information according to an embodiment of the present application.
FIG. 9 is a diagram illustrating yet another configuration of code type indication information according to an embodiment of the present application.
FIG. 10 is a diagram illustrating still another configuration of code type indication information according to an embodiment of the present application.
FIG. 11 is a block diagram of a communication apparatus according to an embodiment of the present application.
FIG. 12 is a block diagram of another communication apparatus according to an embodiment of the present application.
FIG. 13 is a diagram illustrating the structure of a communication device according to an embodiment of the present application.

### DETAILED DESCRIPTION

Embodiments of the present application are described below in conjunction with drawings. The present application is described below in conjunction with accompanying drawings of the embodiments. The examples given are only used to explain the present application.

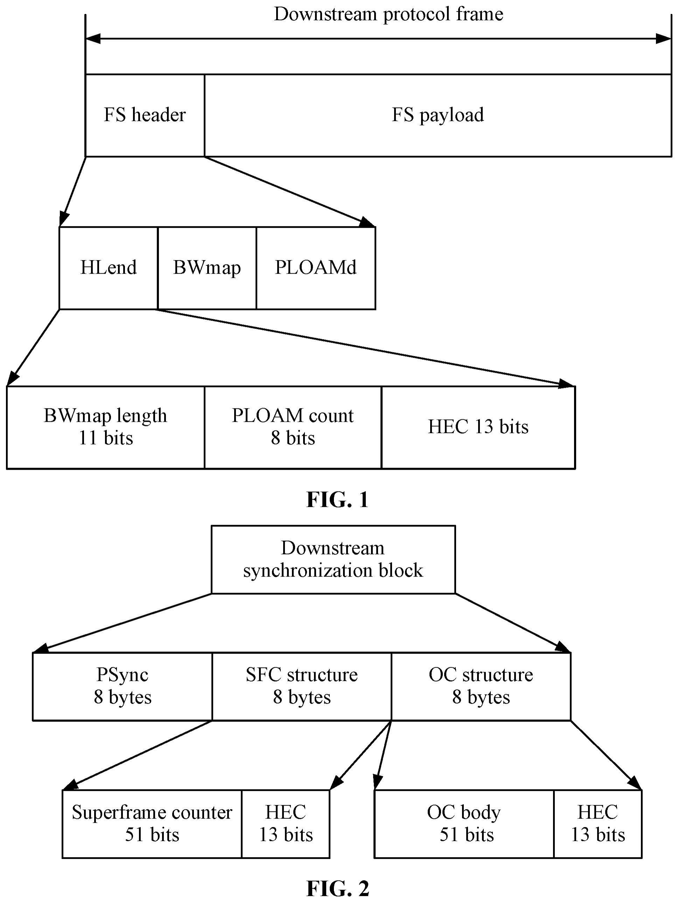

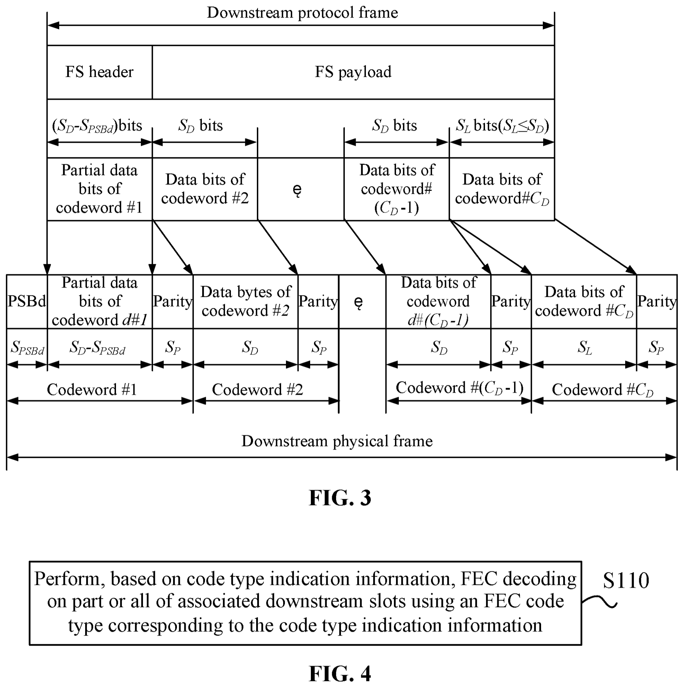

FIG. 1 is a diagram illustrating a configuration of a downstream protocol frame according to an embodiment of the present application. FIG. 2 is a diagram illustrating a configuration of a downstream synchronization block according to an embodiment of the present application. FIG. 3 is a diagram illustrating the structure of a downstream physical frame according to an embodiment of the present application. In the downstream defined in the ITU-T G.9804.2 standard, an OLT device firstly constructs a protocol frame, also referred to as a framing sublayer (FS) frame, as shown in FIG. 1, adds a physical synchronization block for downstream (PSBd) as shown in FIG. 2, inserts FEC parity information in a manner as shown in FIG. 3 to form a physical frame (also referred to as a PHY frame), and then sends the physical frame. The physical frame is sent every 125 microseconds and carries multiple data frames. Therefore, in embodiments of the present application, the physical frame may also be referred to as a superframe or a downstream superframe. The protocol frame includes a protocol frame header, also referred to as an FS header, and a protocol frame payload. The protocol frame header includes an upstream bandwidth mapping partition (BWmap) and a physical layer operations, administration and maintenance for downstream (PLOAMd). The lengths of the BWmap and PLOAMd are indicated in the HLend structure. For the purpose of easy description, embodiments of the present application may refer to the FS header as a management information partition. The management information partition may be extended in subsequent implementations, and its transmission position may also be adjusted.

In the PON system, for different link conditions, three FEC code types can be configured in the downstream, similar to the upstream. The three FEC code types are the HT code type, DE code type, and HM code type. The DE code type may be used by default, or any supported FEC code type (also referred to as a code type) may be used. The code type used in the downstream is related to the downstream link condition. When the link quality is good, the HT code type is used to achieve better bandwidth efficiency; when the link quality is poor, the HM code type is used to provide enhanced error correction capability. The code type used in the downstream can be switched for a single ONU or uniformly switched for all ONUs.

In embodiments of the present application, an FEC code block (also referred to as a code block) may likewise be referred to as an FEC codeword (or codeword for short). An FEC code block consists of two parts: a data portion and a parity portion. The FEC code type is defined by a length of the FEC code block and a length of the data portion. Different FEC code types are derived from a common FEC code type, and the common FEC code type is referred to as the mother code type. Each of the different FEC code types may be derived from the mother code type by reducing the data portion, the parity portion, or both the data portion and parity portion of the mother code type. In this context, a code block of the mother code type is a complete code block, while a code block of an FEC code type derived from the mother code type is an incomplete code block. Furthermore, the data portion and/or the parity portion of the code block of the FEC code type derived from the mother code type, may be further reduced to obtain a further reduced code block, and in this case, the code block of the FEC code type is a complete code block, while the further reduced code block is an incomplete code block.

In an embodiment, FIG. 4 is a flowchart of a communication method according to an embodiment of the present application. This embodiment is applied to flexible switching of FEC code types in the downstream. This embodiment may be executed by a first communication device. Exemplarily, the first communication device may be an ONU device. As shown in FIG. 4, this embodiment includes S110.

In S110, based on code type indication information, FEC decoding is performed on part or all of associated downstream slots using an FEC code type corresponding to the code type indication information.

Code type indication information is received from a second communication device and is used to indicate an FEC code type used in at least one of the associated downstream slots. In the embodiment, a second communication device establishes a communication connection with the first communication device. In the PON system, the second communication device may be an OLT device. The OLT device and the ONU device may be connected and communicate with each other through an intermediate ODN. In the embodiments, the at least one associated downstream slot refers to one or more downstream slots indicated by the code type indication information. The code type indication information may indicate the FEC code type used in one or more associated downstream slots. Exemplarily, the code type indication information may indicate the FEC code type for one or more slots at the front portion of a downstream superframe or for other specified slot positions in the downstream superframe.

Based on code type indication information, FEC decoding is performed using an FEC code type corresponding to the code type indication information for a corresponding slot.

In the embodiment, after receiving the code type indication information sent by the second communication device, the first communication device may determine the FEC code type used in at least one associated downstream slot based on the code type indication information and then perform FEC decoding on a corresponding FEC code block using an FEC code type used in part or all of the associated downstream slots. The corresponding FEC code block may be an FEC code block with a code type matching the first communication device or an FEC code block belonging to the slot associated with the first communication device.

In an embodiment, the communication method applied to the first communication device also includes performing FEC decoding, based on default configuration information, on part or all of the associated downstream slots using an FEC code type corresponding to the default configuration information, where the default configuration information is used to indicate an FEC code type used in at least one of the associated downstream slots. The associated downstream slot of the default configuration information is determined by the corresponding FEC code type length and the corresponding FEC code block position. In the embodiment, the first communication device may perform FEC decoding directly based on the default configuration information without requiring the code type indication information. That is, the first communication device may perform FEC decoding using the FEC code type used in part or all of the associated downstream slots and indicated by the default configuration information.

In an embodiment, the code type indication information includes at least one of a downstream synchronization header or a downstream slot mapping partition. In the embodiment, the code type indication information may be represented by a downstream synchronization header or a downstream slot mapping partition. The downstream slot mapping partition may be additional information included in the management information partition.

In an embodiment, the code type indication information comprises a downstream synchronization header, and the downstream synchronization header is used to indicate the FEC code type for one or more associated downstream slots. The downstream synchronization header may be located within its associated downstream slot or outside its associated downstream slot. The associated downstream slot of the downstream synchronization header is determined by the corresponding FEC code type length and the corresponding FEC code block position. In a case where the downstream synchronization header is located within its associated downstream slot, the identification of the downstream synchronization header by the first communication device may not depend on the FEC code type decoding of the associated downstream slot of the downstream synchronization header, although the FEC code type decoding of the associated downstream slot of the downstream synchronization header may be used to confirm the identification of the downstream synchronization header. In the embodiment, the one or more associated downstream slot refers to one or more slots in the downstream, with no limitation on the slot position. The downstream synchronization header may variably indicate the FEC code type for one or more slots. In an embodiment, the downstream synchronization header may indicate the FEC code type for one or more associated downstream slots at the front portion of a downstream superframe. In an embodiment, in a case where only the downstream synchronization header is used to indicate the FEC code type of the associated downstream slot, the downstream synchronization header may indicate the FEC code type used for the entirety of a downstream superframe.

In an embodiment, the code type indication information comprises a downstream synchronization header, and the associated downstream slots of the downstream synchronization header include slots corresponding to at least one FEC code block at a front portion of a downstream superframe or slots corresponding to the entirety of a downstream superframe; and based on the downstream synchronization header, one or more FEC code blocks whose code type matches the first communication device are decoded among the at least one FEC code block at the front portion of the downstream superframe, or the entirety of the downstream superframe is decoded using a code type corresponding to the downstream synchronization header. In the embodiment, in the case where the code type indication information comprises a downstream synchronization header, the downstream synchronization header may indicate the FEC code type used in slots corresponding to at least one FEC code block at the front portion of a downstream superframe or the FEC code type used in slots corresponding to the entirety of the downstream superframe. In the case where the associated downstream slots of the downstream synchronization header are slots corresponding to at least one FEC code block at the front portion of a downstream superframe, the first communication device decodes, based on the downstream synchronization header, one or more FEC code blocks whose code type matches the first communication device among the at least one FEC code block at the front portion of the downstream superframe. In the case where the associated downstream slots of the downstream synchronization header are the slots corresponding to the entirety of a downstream superframe, the first communication device decodes the entirety of the downstream superframe using the FEC code type indicated by the downstream synchronization header.

In an embodiment, the associated downstream slot of the downstream synchronization header includes one of the following: slots corresponding to the entirety of a downstream superframe, slots corresponding to the first FEC code block of a downstream superframe, slots corresponding to each of multiple FEC code blocks at the front portion of a downstream superframe, or slots corresponding to an FEC code block associated with each of multiple downstream synchronization headers in a downstream superframe.

In an embodiment, in a case where the downstream synchronization header is used to indicate the FEC code type for slots corresponding to the entirety of a downstream superframe, uniform switching of the FEC code type in the downstream is performed based on the downstream synchronization header.

In an embodiment, in a case where the downstream synchronization header is used to indicate the FEC code type for slots corresponding to the first FEC code block of a downstream superframe, the FEC code type for the slots corresponding to the first FEC code block is an FEC code type commonly supported by all first communication devices, and flexible switching of the FEC code type in the downstream is performed based on the downstream synchronization header, the FEC code type commonly supported by all first communication devices, and a downstream slot mapping partition included in the first FEC code block.

In an embodiment, in a case where the downstream synchronization header is used to indicate the FEC code types for slots corresponding to each of multiple FEC code blocks at the front portion of a downstream superframe, the FEC code types for the multiple FEC code blocks at the front portion of the downstream superframe are all FEC code types specified in a passive optical network system or several FEC code types supported by the first communication device, and flexible switching of the FEC code types in the downstream is performed based on the downstream synchronization header and a downstream slot mapping partition included in each of the multiple FEC code blocks at the front portion of the downstream superframe.

In an embodiment, in a case where the downstream synchronization header is used to indicate the FEC code types for slots corresponding to an FEC code block associated with each downstream synchronization header in a downstream superframe, the FEC code types for the slots corresponding to an FEC code block associated with each downstream synchronization header in the downstream superframe are all FEC code types specified in a passive optical network system or several FEC code types supported by the first communication device, and flexible switching of the FEC code types in the downstream is performed based on the downstream synchronization header and a downstream slot mapping partition included in an FEC code block associated with each downstream synchronization header. An FEC code block associated with each downstream synchronization header may be an FEC code block immediately following each downstream synchronization header or an FEC code block including each downstream synchronization header.

In an embodiment, the associated downstream slots of the default configuration information are slots corresponding to at least one FEC code block at a front portion of a downstream superframe; and based on the default configuration information, one or more FEC code blocks whose code type matches the first communication device among the at least one FEC code block are decoded at the front portion of the downstream superframe. In the embodiment, in the case where the default configuration information is used to indicate the FEC code types for slots corresponding to one or more FEC code blocks at the front portion of a downstream superframe, the first communication device may decode, based on the default configuration information, a code block whose code type matches the code type supported by the first communication device among one or more FEC code blocks at the front portion of the downstream superframe. The FEC code type corresponding to at least one FEC code block at the front portion of the downstream superframe includes all FEC code types specified in the passive optical network system or several FEC code types supported by the first communication device, and flexible switching of the FEC code type in the downstream is performed based on the default configuration information and a downstream slot mapping partition included in each of the at least one FEC code block at the front portion of the downstream superframe.

In an embodiment, the code type indication information comprises a downstream slot mapping partition, and the associated downstream slots of the downstream slot mapping partition are specified associated downstream slots in a downstream superframe; and based on the downstream slot mapping partition, an FEC code block in an associated downstream slot related to the first communication device is decoded using a code type corresponding to the downstream slot mapping partition. An associated downstream slot related to the first communication device may be a slot where the FEC code type used matches the FEC code type supported by the first communication device or a slot belonging to the first communication device.

In the embodiment, in a case where only the downstream slot mapping partition is used to carry the code type indication information, the FEC code type used in the associated downstream slots corresponding to one or more code blocks at the front portion of a downstream superframe is set by default, and the downstream slot mapping partition is carried in these FEC code types.

In an embodiment, the downstream slot mapping partition includes at least one code type to slot entry, and the at least one code type to slot entry is used to indicate an FEC code type used in a specified associated downstream slot; and in a case where an FEC code type indicated by the at least one code type to slot entry is consistent with an FEC code type supported by the first communication device, decoding is performed in an associated downstream slot corresponding to the at least one code type to slot entry using a code type corresponding to the at least one code type to slot entry. In the embodiment, the code type to slot entry may indicate the FEC code type used in one or more specified slots. If the FEC code type indicated by the code type to slot entry matches the FEC code type supported by the first communication device, the first communication device may perform decoding in the associated downstream slot corresponding to the code type to slot entry using the corresponding FEC code type.

In an embodiment, the downstream slot mapping partition also includes at least one ONU to slot entry, and the ONU to slot entry is used to indicate a first communication device to which a specified associated downstream slot belongs. If the ONU to slot entry belongs to the first communication device, decoding is performed in an associated downstream slot corresponding to a code type to slot entry associated with the ONU to slot entry using a corresponding code type, or decoding is performed in a slot corresponding to the ONU to slot entry using a corresponding code type. In an embodiment, the association between an ONU to slot entry and a code type to slot entry is as follows: One code type to slot entry corresponds to multiple ONU to slot entries, that is, the slots corresponding to multiple ONU to slot entries exactly constitute the slot corresponding to the code type to slot entry, or one code type to slot entry includes multiple ONU to slot entries, that is, the slots corresponding to multiple ONU to slot entries are included in the slot corresponding to the code type to slot entry. In an embodiment, the slots occupied by multiple ONU to slot entries are equivalent to the slot occupied by one code type to slot entry, or the slots occupied by multiple ONU to slot entries are included in the slot occupied by one code type to slot entry. In the embodiment, the ONU to slot entry may indicate which first communication device (that is, ONU device) one or more specified slots belong to. If the ONU to slot entry indicates that the ONU device to which the associated downstream slot belongs to is the first communication device, the first communication device may perform decoding in the associated downstream slot corresponding to a code type to slot entry associated with the ONU to slot entry using a corresponding code type, or perform decoding in the slot corresponding to the ONU to slot entry using a corresponding code type.

In an embodiment, the specified associated downstream slot of the downstream slot mapping partition is defined by a start time and a slot length, or by a start time and an end time.

In an embodiment, when the code type indication information comprises a downstream synchronization header, the code type indication information is used to indicate an FEC code type used in slots corresponding to the entirety of a downstream superframe; and based on the code type indication information, decoding is performed on the entirety of the downstream superframe using a code type corresponding to the code type indication information.

In an embodiment, a downstream slot mapping partition is carried in at least one of the associated downstream slots indicated by the default configuration information or by the downstream synchronization header; and the downstream slot mapping partition is parsed after an FEC code block that matches an FEC code type supported by the first communication device in the at least one of the associated downstream slots indicated by the default configuration information or by the downstream synchronization header is parsed.

In an embodiment, the default configuration information or the downstream synchronization header is used to indicate a code type in a slot corresponding to a first FEC code block of a downstream superframe; and based on the default configuration information or the downstream synchronization header, the first FEC code block is decoded, and a downstream slot mapping partition is parsed. In the embodiment, in a case where the downstream synchronization header is used to indicate the code type for the slot corresponding to the first FEC code block, the first FEC code block may be a complete code block and includes a management information partition, and the management information partition has been extended to include a downstream slot mapping partition. In a case where the downstream synchronization header is used to indicate the code type for the slot corresponding to the first FEC code block, the downstream slot mapping partition may be directly parsed from the first FEC code block.

In an embodiment, in a case where the code type indication information comprises a downstream synchronization header, it is used to indicate the code type for slots corresponding to the entirety of the downstream superframe, and all first communication devices associated with the second communication device support the same FEC code type. In the embodiment, in a case where the downstream synchronization header is used to indicate the code type for slots corresponding to the entirety of the downstream superframe, different downstream synchronization headers may represent different FEC code types for the slots corresponding to the entirety of the downstream superframe. Exemplarily, it is assumed that downstream synchronization header 1 indicates that the slots corresponding to the entirety of the downstream superframe use the HT code type; downstream synchronization header 2 indicates that the slots corresponding to the entirety of the downstream superframe use the DE code type; downstream synchronization header 3 indicates that the slots corresponding to the entirety of the downstream superframe use the HM code type. In the embodiment, after acquiring the downstream synchronization header sent by the second communication device, the first communication device determines the type of FEC code type indicated (for example, the HT code type, DE code type, or HM code type) based on the downstream synchronization header and performs decoding using the corresponding FEC code type.

In an embodiment, in a case where the FEC code type used by one or more FEC code blocks at the front portion of a downstream superframe is indicated by both the downstream synchronization header (or default configuration information) and the downstream slot mapping partition, the FEC code type indicated by the downstream synchronization header (or default configuration information) for the one or more FEC code blocks at the front portion of the downstream superframe prevails. In an embodiment, in a case where the downstream synchronization header (or default configuration information) is used to indicate the FEC code type for a slot corresponding to one or more FEC code blocks at the front portion of a downstream superframe, the downstream slot mapping partition may be used to indicate the FEC code types for slots corresponding to other FEC code blocks.

In an embodiment, the default configuration information or the downstream synchronization header is used to indicate a code type in slots corresponding to at least two FEC code blocks at a front portion of a downstream superframe, and the communication method applied to the first communication device also includes performing FEC decoding, based on the default configuration information or the downstream synchronization header, on an FEC code block corresponding to an FEC code type supported by the first communication device among the at least two FEC code blocks at the front portion of the downstream superframe, and parsing a downstream slot mapping partition. In the embodiment, to accommodate scenarios where not all first communication devices support the same FEC code type, the default configuration information or the downstream synchronization header may be used to indicate the code types for slots corresponding to multiple FEC code blocks at the front portion of a downstream superframe. After the first communication device receives the code type indication information sent by the second communication device, the first communication device parses the code type indication information or directly parses based on the default configuration information to determine the code types for slots corresponding to multiple FEC code blocks at the front portion of the downstream superframe. The first communication device then needs to parse the FEC code block corresponding to the FEC code type the first communication device supports. Additionally, each FEC code block includes a management information partition, and the first communication device acquires the corresponding downstream slot mapping partition from the management information partition included in the FEC code block corresponding to the FEC code type the first communication device supports. Exemplarily, it is assumed that downstream synchronization header 4 indicates the code types for slots corresponding to the first three FEC code blocks (for example, the first FEC code block uses code type 1, the second FEC code block uses code type 2, the third FEC code block uses code type 3), and the first communication device supports code type 2. After powering on and operating in a state, the first communication device may parse the code type for a slot corresponding to one of the first three FEC code blocks, for example, parsing the second FEC code block corresponding to code type 2 the first communication device supports among the first three FEC code blocks to obtain the downstream slot mapping partition corresponding to the second FEC code block.

In an embodiment, the code type indication information comprises at least two downstream synchronization headers, and each of the at least two downstream synchronization headers has a corresponding associated downstream slot; one of the at least two downstream synchronization headers is identified, decoding is performed in a corresponding associated downstream slot using a corresponding FEC code type, and a downstream slot mapping partition is parsed. In the embodiment, in a case where multiple downstream synchronization headers and multiple downstream slot mapping partitions are used to indicate the FEC code types for part or all of the associated downstream slots, a downstream synchronization header may be added in each of the multiple FEC code blocks at the front portion of a downstream superframe or before each FEC code block. Each downstream synchronization header indicates the code type for the slot corresponding to the subsequent FEC code block or the code type for the slot corresponding to the FEC code block including the downstream synchronization header. Each of the multiple FEC code blocks at the front portion of the downstream superframe carries a downstream slot mapping partition, indicating the FEC code types used in slots following the multiple FEC code blocks at the front portion of the downstream superframe. The first communication device may identify one of the downstream synchronization headers corresponding to the code type indication information and perform decoding in the associated downstream slot corresponding to the downstream synchronization header using the corresponding FEC code type to parse the corresponding downstream slot mapping partition.

In an embodiment, the FEC code block or the associated downstream slot includes a management information partition, where the management information partition at least includes a downstream slot mapping partition or size information of a downstream slot mapping partition. The size information of the downstream slot mapping partition is used to indicate the size of the downstream slot mapping partition or to indicate at least one of the number of code type to slot entries included in the downstream slot mapping partition or the number of ONU to slot entries included in the downstream slot mapping partition. The downstream slot mapping partition includes at least one of: at least one code type to slot entry or at least one ONU to slot entry. The at least one code type to slot entry indicates an FEC code type used in a corresponding slot, and the at least one ONU to slot entry indicates a first communication device to which the corresponding slot belongs. In the embodiment, one or more FEC code blocks at the front portion of a downstream superframe each include a management information partition, and the management information partition is extended to include a downstream slot mapping partition and size information of the downstream slot mapping partition (referred to as dHLend). The dHLend includes the length of the downstream slot mapping partition (referred to as dBWmap length) used to indicate the number of code type to slot entries and/or ONU to slot entries included in the downstream slot mapping partition. Each FEC code block including a management information partition may be understood as an FEC code block where the associated downstream slot of the downstream synchronization header is located or an FEC code block configured by default.

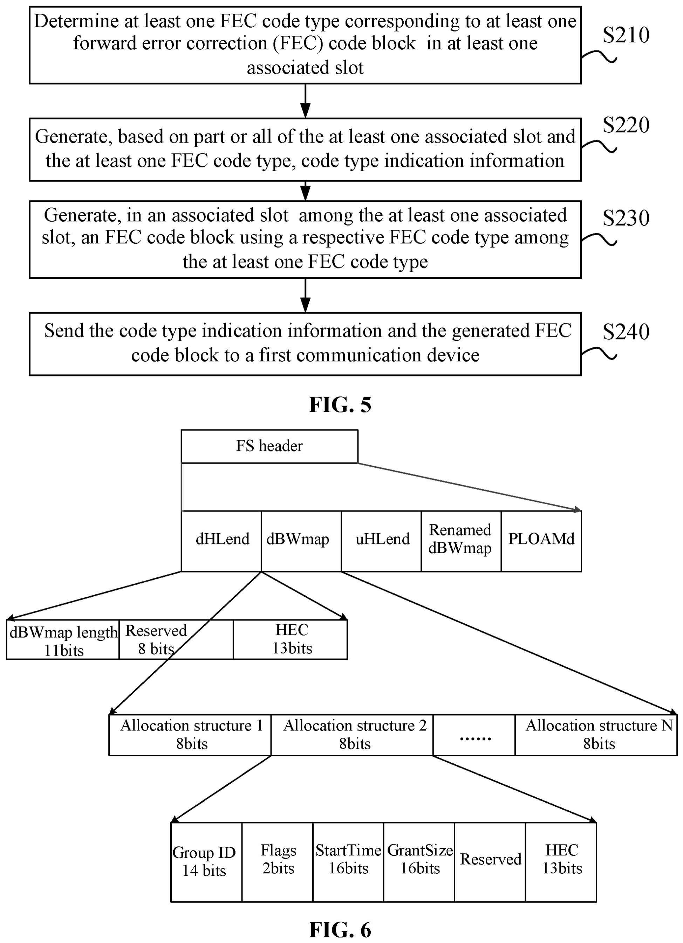

In an embodiment, FIG. 5 is a flowchart of another communication method according to an embodiment of the present application. This embodiment is applied to flexible switching of FEC code types in the downstream. This embodiment may be executed by a second communication device. Exemplarily, the second communication device may be an OLT device. As shown in FIG. 5, this embodiment includes S210 to S240.

In S210, at least one FEC code type corresponding to at least one FEC code block in at least one associated slot is determined.

In S220, code type indication information is generated based on part or all of the at least one associated slot and the at least one FEC code type.

The code type indication information is used to indicate an FEC code type used in at least one associated downstream slot.

In S230, in an associated slot among the at least one associated slot, an FEC code block is generated using a respective FEC code type among the at least one FEC code type.

In S240, the code type indication information and the generated FEC code block are sent to a first communication device.

In the embodiment, the second communication device may acquire an ONU device to which an associated downstream slot belongs and determine the FEC code type corresponding to an FEC code block in an associated downstream slot based on the FEC code type supported by the ONU device; alternatively, the second communication device may determine the FEC code type corresponding to an FEC code block in an associated downstream slot based on the FEC code type uniformly supported by the downstream superframe. After determining the FEC code type used in a slot corresponding to one or more FEC code blocks at the front portion of a downstream superframe, if the FEC code types used in two adjacent slots are different, the FEC code type is switched; then, corresponding code type indication information is generated based on the FEC code type used in the slot corresponding to each FEC code block and the FEC code block; the code type indication information is sent to the first communication device to enable the first communication device to perform FEC decoding using a corresponding FEC code type for a corresponding slot based on the code type indication information and perform data transmission.

In an embodiment, an FEC code block in at least one associated downstream slot at a front portion of a downstream superframe and the corresponding FEC code type of the FEC code block are configured by default.

In an embodiment, in a case where the code type indication information indicates an FEC code type used in at least one associated downstream slot at a front portion of a downstream superframe or indicates an FEC code type used in all slots corresponding to a downstream superframe, the code type indication information comprises a downstream synchronization header; and based on the at least one associated downstream slot at the front portion of the downstream superframe or the all slots corresponding to the downstream superframe and the corresponding FEC code type, the value of the downstream synchronization header is determined. In a case where the FEC code type for the associated downstream slot corresponding to an FEC code block can be dynamically indicated, the code type indication information may be carried in the downstream synchronization header.

In an embodiment, in a case where the code type indication information indicates an FEC code type used in a specified associated downstream slot of a downstream superframe, the code type indication information comprises a downstream slot mapping partition; and based on the specified associated downstream slot of the downstream superframe and the corresponding FEC code type, the downstream slot mapping partition is generated. In a case where the code type indication information indicates an FEC code type for one or more specific slots corresponding to an FEC code block, the code type indication information may be carried in the downstream slot mapping partition.

In an embodiment, the downstream slot mapping partition includes at least one code type to slot entry, and the at least one code type to slot entry is used to indicate an FEC code type used in a specified associated downstream slot; based on the specified associated downstream slot and the FEC code type used in the specified associated downstream slot, the at least one code type to slot entry is generated.

In an embodiment, the downstream slot mapping partition also includes at least one ONU to slot entry, and the at least one ONU to slot entry is used to indicate a first communication device to which the specified associated downstream slot belongs; and based on the specified associated downstream slot and the first communication device to which the specified associated downstream slot belongs, the at least one ONU to slot entry is generated.

In an embodiment, the specified associated downstream slot is defined by a start time and a slot length, or by a start time and an end time.

In an embodiment, a downstream slot mapping partition is carried in at least one associated downstream slot at a front portion of a downstream superframe indicated by a downstream synchronization header or by default configuration information. In the embodiment, in a case where both the downstream synchronization header and the downstream slot mapping partition are used to indicate the FEC code type of one or more slots, the one or more slots indicated by the downstream slot mapping partition are included in the one or more associated downstream slots indicated by the downstream synchronization header.

In the embodiment, the downstream synchronization header indicates a code type used in an associated downstream slot corresponding to a first FEC code block of a downstream superframe, and based on an FEC code type used by the first FEC code block of the downstream superframe, the value of the downstream synchronization header is determined, and a downstream slot mapping partition is carried in the first FEC code block. In the embodiment, in a case where the downstream synchronization header is used to indicate the FEC code type of the slot corresponding to the first FEC code block, a downstream slot mapping partition may be added to the management information partition included in the first FEC code block. The second communication device may generate a corresponding downstream slot mapping partition based on the specified associated downstream slot, the FEC code type used, and the ONU device to which the slot belongs, and configure the downstream slot mapping partition in multiple FEC code blocks at the front portion of the downstream superframe.

In an embodiment, a downstream synchronization header indicates a code type used in slots corresponding to the entirety of a downstream superframe; and based on a code type used by the entirety of the downstream superframe, the value of the downstream synchronization header is determined. In the embodiment, in a case where the downstream synchronization header is used to indicate the FEC code type of the slots corresponding to the entirety of the downstream superframe, the second communication device acquires the FEC code type commonly supported by all first communication devices and switches the FEC code type of the slots corresponding to the entirety of the downstream superframe to the FEC code type commonly supported by all first communication devices, thereby achieving uniform switching of the FEC code type for the slots in the downstream.

In an embodiment, a downstream synchronization header indicates a code type used in slots corresponding to at least two FEC code blocks at a front portion of a downstream superframe; and based on the slots corresponding to the at least two FEC code blocks at the front portion of the downstream superframe and the used code type, the value of the downstream synchronization header is determined, and a downstream slot mapping partition is carried in each of the at least two FEC code blocks at the front portion of the downstream superframe. The multiple FEC code blocks at the front portion of the downstream superframe are sequentially composed of FEC code blocks corresponding to the FEC code types supported by each first communication device. In the embodiment, to accommodate scenarios where not all first communication devices support the same FEC code type, the downstream synchronization header may be used to indicate the code types for slots corresponding to multiple FEC code blocks at the front portion of a downstream superframe. The second communication device may generate a corresponding downstream slot mapping partition based on a specified associated downstream slot, an FEC code type used, and an ONU device to which the slot belongs, and configure the downstream slot mapping partition in multiple FEC code blocks at the front portion of the downstream superframe.

In an embodiment, the code type indication information comprises at least two downstream synchronization headers, and each downstream synchronization header indicates an FEC code type used in an associated downstream slot in a downstream superframe; and based on an associated downstream slot in each downstream superframe and an FEC code type used by the associated downstream slot, the value of each of the at least two downstream synchronization headers is determined, and a downstream slot mapping partition is carried in the associated downstream slot in the each downstream superframe. In the embodiment, the second communication device may generate a corresponding downstream slot mapping partition based on the FEC code type supported by a first communication device and include the downstream slot mapping partition in the associated downstream slot of the downstream synchronization header.

In an embodiment, default configuration information indicates a code type used in an associated downstream slot corresponding to a first FEC code block of a downstream superframe, and a downstream slot mapping partition is carried in the first FEC code block.

In an embodiment, default configuration information indicates a code type used in slots corresponding to at least two FEC code blocks at a front portion of a downstream superframe, and a downstream slot mapping partition is carried in each of the at least two FEC code blocks at the front portion of the downstream superframe.

Parameters involved in the communication method applied to the second communication device are the same as those in the preceding embodiments and are explained in the corresponding parameters of the preceding embodiments, which will not be repeated here.

In an embodiment, based on the flowchart of the communication method shown in FIG. 5, the FEC code type of one or more associated downstream slots at the front portion of a downstream superframe is configured by default, and the default configuration may be the FEC code type of one or more associated downstream slots at the front portion of the downstream superframe indicated by a downstream synchronization header as described in the preceding embodiments. In this embodiment, the downstream synchronization header remains unchanged and does not indicate the FEC code type of any associated downstream slot.

In an embodiment, a downstream slot mapping partition is introduced in the downstream to indicate FEC code types used in different associated downstream slots or specified slots. The specified slot may be defined by a start time and an end time, or by a start time and a slot length. The start time and end time are represented by the byte or byte group number in the downstream superframe. That is, the start time and end time indicate the specific byte or byte group in the downstream superframe. The slot length is represented by the number of bytes or byte groups in the downstream superframe.

FIG. 6 is a diagram illustrating an implementation of a downstream slot mapping partition according to an embodiment of the present application. As shown in FIG. 6, the management information partition (referred to as the FS header) is extended, and the original HLend and BWmap fields, which indicate upstream slot allocation, are renamed to uHLend and uBWmap, respectively, while their content remains unchanged. Additionally, dHLend and dBWmap, which represent the downstream slot mapping partition, are added to the FS header. The dBWmap length in dHLend indicates the number N of slot entries included in dBWmap. dBWmap includes N slot entries (that is, the number of Allocation Structures), and the number of slot entries is determined by the sum of the number of code type to slot entries and ONU to slot entries. Exemplarily, dBWmap may include one or more code type to slot entries and n ONU to slot entries corresponding to the code type to slot entries. Each code type to slot entry is used to indicate the FEC code type used in a corresponding slot (Flags=00b indicates that a corresponding slot is a code type slot, and the Group-ID field indicates the FEC-ID, that is, the FEC code type used). Each ONU to slot entry is used to indicate an ONU to which a corresponding slot belongs (Flags=01b indicates that a corresponding slot is an ONU slot, and the Group-ID field indicates the ONU-ID). The slot may be represented by StartTime and GrantSize, indicating the start time of a slot and slot length. Exemplarily, in a case where the Flags field is 00b, the Group-ID indicates the FEC-ID, that is, the ID corresponding to an FEC code type, and the Allocation Structure indicates an FEC slot, that is, a slot using a corresponding FEC code type. In a case where the Flags field is 01b, the Group-ID indicates the ONU-ID, and the Allocation Structure indicates an ONU slot, that is, a slot allocated to the ONU. In a case where the Flags field is 10 or 11, the Group-ID indicates reserved.

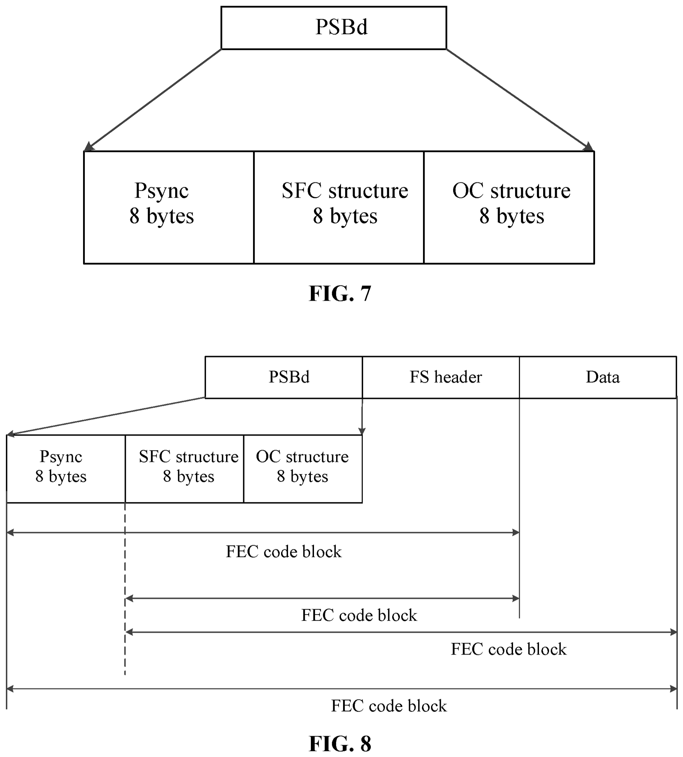

In an embodiment, FIG. 7 is a diagram illustrating a configuration of code type indication information according to an embodiment of the present application. In this embodiment, an example where the first communication device is an ONU device, the second communication device is an OLT device, and the downstream synchronization header is represented by PSync is used to describe the process of uniformly switching the FEC code type used by all ONU devices. As shown in FIG. 7, the downstream synchronization block (referred to as PSBd) includes a downstream synchronization header (referred to as PSync), an SFC structure, and an OC structure. The downstream synchronization header occupies 8 bytes, and different values of these 8 bytes represent the use of different FEC code types.

In the embodiment, different PSync values may be used to indicate FEC code types used by a corresponding downstream superframe. For example, PSync1 indicates that the corresponding downstream superframe uses the HT code type, PSync2 indicates that the corresponding downstream superframe uses the DE code type, and PSync3 indicates that the corresponding downstream superframe uses the HM code type. The ONU device may determine the type of FEC code type used by a downstream superframe by acquiring the downstream synchronization header and then perform decoding using a corresponding FEC code type.

In a case where the FEC code type is the default code type, the downstream superframe may include an integer number of FEC code blocks and achieve 4-codeword interleaving. That is, during transmission, the first bit of four codewords, the second bits of four codewords, ..., and the last bit of four codewords are sequentially sent. In a case where the FEC code type is HT or HM codewords, the tail of the downstream superframe may include incomplete codewords. Since the codeword size differs from the default code type, it may be necessary to reselect the number of interleaved codewords. In a case where HT and HM codewords are configured, incomplete codewords may be allowed at the tail of the downstream superframe, and data may not be sent in these incomplete codewords at the tail of the downstream superframe. Interleaving may be performed with units other than 4 codewords, such as 2-codeword, 3-codeword, or 5-codeword interleaving. An example is used with 2-codeword interleaving. During transmission, the first bit of two codewords, the second bit of two codewords, ..., and finally the last bit of two codewords are sequentially sent. Interleaving with 3 codewords, 5 codewords, or other numbers of codewords is not further detailed here.

PSync is a code type that is not easily mistaken, and even if several bits are erroneous, it is not easily misidentified as another code type. PSync provides a certain level of fault tolerance. The determination of PSync can be independent of FEC parity checking and is not constrained by FEC parity checking.

In an embodiment, FIG. 8 is a diagram illustrating another configuration of code type indication information according to an embodiment of the present application. In this embodiment, an example where the first communication device is an ONU device, the second communication device is an OLT device, and the downstream synchronization header is represented by PSync is used to describe the process where PSync indicates the FEC code type for a slot corresponding to a first FEC code block. As shown in FIG. 8, the downstream synchronization block (referred to as PSBd) includes a downstream synchronization header (referred to as PSync), an SFC structure, and an OC structure. The downstream synchronization header occupies 8 bytes, and different values of these 8 bytes represent that the first FEC code block uses different FEC code types.

In the embodiment, PSync indicates the FEC code type for the slot corresponding to a first FEC code block. The first FEC code block may be a complete code block, and in addition to the FS header, the remaining data part may carry service data or idle padding. Alternatively, the first FEC code block may be an incomplete code block with a shortened data part of a specified length, where the data part only includes the FS header.

Exemplarily, PSync1 indicates that the first FEC code block uses the HT code type, PSync2 indicates that the first FEC code block uses the DE code type, and PSync3 indicates that the first FEC code block uses the HM code type. The ONU device may parse the dBWmap from the FS header included in the first FEC code block to acquire FEC slots and ONU slots related to the ONU device.

To support codeword interleaving or other requirements, the dBWmap may or may not indicate the code type for the slot corresponding to the first FEC code block. In a case where both PSync and dBWmap indicate the code type for the slot corresponding to the first FEC code block, the FEC code type indicated by PSync prevails.

As shown in FIG. 8, an FEC code block may include a PSBd and an FS header, or part of the fields in a PSBd and an FS header, or part of the fields in a PSBd, an FS header, and data other than the FS header, or a PSBd, an FS header, and data other than the FS header. In an embodiment, the starting position of an FEC code block may be the starting position of a PSync or the starting position of an SFC structure.

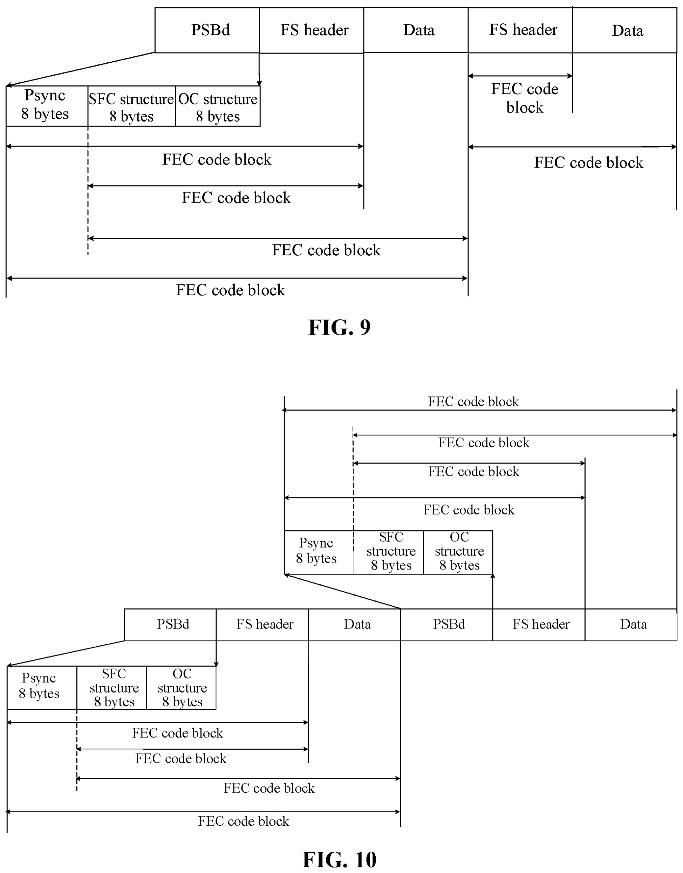

In an embodiment, FIG. 9 is a diagram illustrating yet another configuration of code type indication information according to an embodiment of the present application. In this embodiment, an example where the first communication device is an ONU device, the second communication device is an OLT device, and the downstream synchronization header is represented by PSync is used to describe the process where a PSync indicates the repetition of an FS header and an FEC code type used by a corresponding FEC codeword. As shown in FIG. 9, the downstream synchronization block (referred to as PSBd) includes a downstream synchronization header (referred to as PSync), an SFC structure, and an OC structure. The downstream synchronization header occupies 8 bytes, and different values of these 8 bytes represent the code type used by one or more FEC code blocks at the front portion of a downstream superframe and the presence of an FS header.

In the embodiment, PSync is used to indicate the repetition of the FS header and the FEC code type used by an FEC codeword (also referred to as an FEC code block) corresponding to each FS header. The FEC codeword may be a complete codeword or an incomplete codeword of a specified length. In the complete codeword, the remaining data part, in addition to an FS header, may carry service data or idle padding, while the incomplete codeword data part only includes an FS header.

Exemplarily, PSync1 indicates that the FS header is repeated 3 times, and the FEC code blocks containing the 3 repeated FS headers use the HT code type, DE code type, and HM code type, respectively. PSync2 indicates that the FS header is repeated 6 times, and the FEC code blocks containing the 6 repeated FS headers use the HT code type, HT code type, DE code type, DE code type, HM code type, and HM code type, respectively, and adjacent FEC code blocks of the same FEC code type use 2-codeword interleaving. PSync3 indicates that the FS header is repeated once and uses the DE code type. The number of FS header repetitions indicated by PSync and the FEC code type used by the FEC code block containing each FS header may be flexibly configured as needed and are not further detailed here.

Each ONU device decodes a corresponding FEC code block based on the FEC code type the ONU device uses, parses the FS header at a corresponding position in the FEC code block, and then parses the dBWmap from the FS header to acquire the FEC slots and ONU slots related to the ONU device.

As shown in FIG. 9, an FEC code block may include a PSBd and an FS header, or part of the fields in a PSBd and an FS header, or part of the fields in a PSBd, an FS header, and data other than the FS header, or a PSBd, an FS header, and data other than the FS header. In an embodiment, the starting position of an FEC code block may be the starting position of a PSync or the starting position of an SFC structure. In an embodiment, an FEC code block may include only the FS header.

In an embodiment, as shown in FIG. 9, the PSync is fixed, and the code type of one or more FEC code blocks at the front portion of a downstream superframe is set by default, and each FEC code block configured by default includes a management information partition. Exemplarily, the code types of three FEC code blocks at the front portion of a downstream superframe are set by default to use the HT code type, DE code type, and HM code type, respectively, and all three code blocks include a management information partition. An ONU using the HT code type decodes the first FEC code block, obtains a downstream slot mapping partition, and does not decode the second and third FEC code blocks based on the default configuration. ONUs using the DE code type or HM code type perform similar processing. Alternatively, the code types of six FEC code blocks at the front portion of a downstream superframe are set by default to use the HT code type, HT code type, DE code type, DE code type, HM code type, and HM code type, respectively, and all six code blocks include a management information partition. Adjacent two code blocks use 2-codeword interleaving. An ONU using the HT code type deinterleaves and decodes the first and second FEC code blocks, obtains the downstream slot mapping partition, and does not decode the third, fourth, fifth, and sixth FEC code blocks based on the default configuration. ONUs using the DE code type or HM code type perform similar processing. Alternatively, the code type of one FEC code block at the front portion of a downstream superframe is set by default to use the DE code type, and this code block includes a management information partition. Other default configuration scenarios are also within the scope of the embodiments of the present application and are not further detailed here.

In an embodiment, FIG. 10 is a diagram illustrating still another configuration of code type indication information according to an embodiment of the present application. In the embodiment, an example where the first communication device is an ONU device, the second communication device is an OLT device, and the downstream synchronization header is represented by PSync is used to describe the process of repeating both the PSync and FS header. As shown in FIG. 10, the downstream synchronization block (referred to as PSBd) includes a downstream synchronization header (referred to as PSync), an SFC structure, and an OC structure. The downstream synchronization header occupies 8 bytes, and different values of these 8 bytes represent the FEC code type used in a slot corresponding to an FEC code block adjacent to the PSync.

In the embodiment, the header of a superframe carries multiple combinations of a PSync, an FS header, and an FEC code type, and different PSync values correspond to the downstream FEC code type used in a slot corresponding to a subsequent adjacent FEC code block. The codeword may be a complete codeword or an incomplete codeword of a specified length. In the complete codeword, the remaining data part, in addition to an FS header, may carry service data or idle padding, while the incomplete codeword data part only includes an FS header.

ONU devices using different downstream FEC code types can identify the corresponding PSync, perform corresponding FEC decoding on an FEC code block corresponding to a subsequent adjacent FS header, parse the FS header and dBWmap, and then acquire their own slots based on the dBWmap to perform FEC decoding and data reception in corresponding slots.

In the embodiment, a PSync and an FEC code type are in a one-to-one correspondence. Exemplarily, three PSync values are defined, each corresponding to one FEC code type. A PSync is added before each FEC code block. This PSync is used to indicate the FEC code type corresponding to an adjacent FEC code block. It is assumed that in the downstream frame structure, the first three FEC code blocks each correspond to a PSync. For example, the first FEC code block corresponds to PSync1 (corresponding to code type 1), the second FEC code block corresponds to PSync2 (corresponding to code type 2), and the third FEC code block corresponds to PSync3 (corresponding to code type 3). After receiving the frame structure, the ONU device identifies a PSync and, based on the PSync value, identifies the FEC code type corresponding to the indicated FEC code block.

As shown in FIG. 10, an FEC code block may include a PSBd and an FS header, or part of the fields in a PSBd and an FS header, or part of the fields in a PSBd, an FS header, and data other than the FS header, or a PSBd, an FS header, and data other than the FS header. In an embodiment, the starting position of an FEC code block may be the starting position of a PSync or the starting position of an SFC structure.

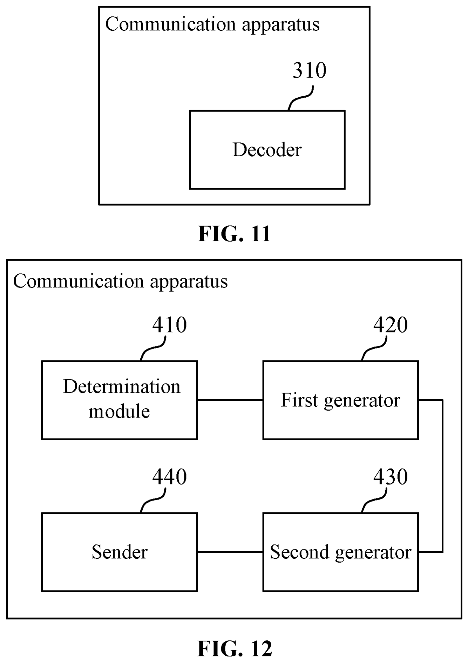

In an embodiment, FIG. 11 is a block diagram of a communication apparatus according to an embodiment of the present application. This embodiment is applied to a first communication device. As shown in FIG. 11, the communication apparatus applied to the first communication device in this embodiment includes a decoder 310.

The decoder 310 is configured to perform, based on code type indication information, FEC decoding on part or all of associated downstream slots using an FEC code type corresponding to the code type indication information, where the code type indication information is received from a second communication device and is used to indicate an FEC code type used in at least one of the associated downstream slots.

In an embodiment, the decoder 310 is also configured to perform FEC decoding, based on default configuration information, on part or all of the associated downstream slots using an FEC code type corresponding to the default configuration information, where the default configuration information is used to indicate an FEC code type used in at least one of the associated downstream slots.

In an embodiment, the code type indication information includes at least one of a downstream synchronization header or a downstream slot mapping partition.

In an embodiment, the code type indication information comprises a downstream synchronization header, and the associated downstream slots of the downstream synchronization header include slots corresponding to at least one FEC code block at a front portion of a downstream superframe or slots corresponding to the entirety of a downstream superframe; and based on the downstream synchronization header, one or more FEC code blocks whose code type matches the first communication device are decoded among the at least one FEC code block at the front portion of the downstream superframe, or the entirety of the downstream superframe is decoded using a code type corresponding to the downstream synchronization header.

In an embodiment, the associated downstream slots of the default configuration information are slots corresponding to at least one FEC code block at a front portion of a downstream superframe; and based on the default configuration information, one or more FEC code blocks whose code type matches the first communication device among the at least one FEC code block are decoded at the front portion of the downstream superframe.

In an embodiment, the code type indication information comprises a downstream slot mapping partition, and the associated downstream slots of the downstream slot mapping partition are specified associated downstream slots in a downstream superframe; and based on the downstream slot mapping partition, an FEC code block in an associated downstream slot related to the first communication device is decoded using a code type corresponding to the downstream slot mapping partition.

In an embodiment, the downstream slot mapping partition includes at least one code type to slot entry, and the at least one code type to slot entry is used to indicate an FEC code type used in a specified associated downstream slot; and in a case where an FEC code type indicated by the at least one code type to slot entry is consistent with an FEC code type supported by the first communication device, decoding is performed in an associated downstream slot corresponding to the at least one code type to slot entry using a code type corresponding to the at least one code type to slot entry.

In an embodiment, the downstream slot mapping partition also includes at least one ONU to slot entry, and the ONU to slot entry is used to indicate a first communication device to which a specified associated downstream slot belongs. If the ONU to slot entry belongs to the first communication device, decoding is performed in an associated downstream slot corresponding to a code type to slot entry associated with the ONU to slot entry using a corresponding code type, or decoding is performed in a slot corresponding to the ONU to slot entry using a corresponding code type.

In an embodiment, the specified associated downstream slot is defined by a start time and a slot length, or by a start time and an end time.

In an embodiment, the code type indication information is used to indicate an FEC code type used in slots corresponding to the entirety of a downstream superframe; and based on the code type indication information, decoding is performed on the entirety of the downstream superframe using a code type corresponding to the code type indication information.

In an embodiment, a downstream slot mapping partition is carried in at least one of the associated downstream slots indicated by the default configuration information or by the downstream synchronization header; and the downstream slot mapping partition is parsed after an FEC code block that matches an FEC code type supported by the first communication device in the at least one of the associated downstream slots indicated by the default configuration information or by the downstream synchronization header is parsed.

In an embodiment, the default configuration information or the code type indication information is used to indicate a code type in a slot corresponding to a first FEC code block of a downstream superframe; and based on the default configuration information or the code type indication information, the first FEC code block is decoded, and a downstream slot mapping partition is parsed.

In an embodiment, in a case where an FEC code type used by the first FEC code block is jointly indicated by the downstream synchronization header and the downstream slot mapping partition, an FEC code type indicated by the downstream synchronization header for the first FEC code block prevails.

In an embodiment, the default configuration information or the code type indication information is used to indicate a code type in slots corresponding to at least two FEC code blocks at a front portion of a downstream superframe, and the decoder is also configured to perform FEC decoding, based on the default configuration information or the code type indication information, on an FEC code block corresponding to an FEC code type supported by the first communication device among the at least two FEC code blocks at the front portion of the downstream superframe, and parse a downstream slot mapping partition.

In an embodiment, the code type indication information comprises at least two downstream synchronization headers, and each of the at least two downstream synchronization headers has a corresponding associated downstream slot; one of the at least two downstream synchronization headers is identified, decoding is performed in a corresponding associated downstream slot using a corresponding FEC code type, and a downstream slot mapping partition is parsed.

In an embodiment, the FEC code block or the associated downstream slot includes a management information partition, where the management information partition at least includes a downstream slot mapping partition or size information of a downstream slot mapping partition. The size information of the downstream slot mapping partition is used to indicate the size of the downstream slot mapping partition or to indicate at least one of the number of code type to slot entries included in the downstream slot mapping partition or the number of ONU to slot entries included in the downstream slot mapping partition.

In an embodiment, the downstream slot mapping partition includes at least one of: at least one code type to slot entry or at least one ONU to slot entry. The at least one code type to slot entry indicates an FEC code type used in a corresponding slot, and the at least one ONU to slot entry indicates a first communication device to which the corresponding slot belongs.

The communication apparatus provided in this embodiment is configured to perform the communication method applied to a first communication device in the embodiment shown in FIG. 4 and has similar implementation principles and technical effects, which are not repeated here.

In an embodiment, FIG. 12 is a block diagram of another communication apparatus according to an embodiment of the present application. This embodiment is applied to a second communication device. As shown in FIG. 12, the communication apparatus applied to the second communication device in this embodiment includes a determination module 410, a first generator 420, a second generator 430, and a sender 440.

The determination module 410 is configured to determine at least one FEC code type corresponding to at least one FEC code block in at least one associated slot. The first generator 420 is configured to generate, based on part or all of the at least one associated slot and the at least one FEC code type, code type indication information, where the code type indication information is used to indicate an FEC code type used in at least one associated downstream slot. The second generator 430 is configured to generate, in an associated slot among the at least one associated slot, an FEC code block using a respective FEC code type among the at least one FEC code type. The sender 440 is configured to send the code type indication information and the generated FEC code block to a first communication device.

In an embodiment, an FEC code block in at least one associated downstream slot at a front portion of a downstream superframe and an FEC code type corresponding to the FEC code block are configured by default.

In an embodiment, the code type indication information indicates an FEC code type used in at least one associated downstream slot at a front portion of a downstream superframe or indicates an FEC code type used in all slots corresponding to a downstream superframe, and the code type indication information comprises a downstream synchronization header; and based on the at least one associated downstream slot at the front portion of the downstream superframe or the all slots corresponding to the downstream superframe and the FEC code type, the value of the downstream synchronization header is determined.

In an embodiment, in a case where the code type indication information indicates an FEC code type used in a specified associated downstream slot of a downstream superframe, the code type indication information comprises a downstream slot mapping partition; and based on the specified associated downstream slot of the downstream superframe and the FEC code type, the downstream slot mapping partition is generated.

In an embodiment, the downstream slot mapping partition includes at least one code type to slot entry, and the at least one code type to slot entry is used to indicate an FEC code type used in a specified associated downstream slot; based on the specified associated downstream slot and the FEC code type used in the specified associated downstream slot, the at least one code type to slot entry is generated.

In an embodiment, the downstream slot mapping partition also includes at least one ONU to slot entry, and the at least one ONU to slot entry is used to indicate a first communication device to which the specified associated downstream slot belongs; and based on the specified associated downstream slot and the first communication device to which the specified associated downstream slot belongs, the at least one ONU to slot entry is generated.

In an embodiment, the specified associated downstream slot is defined by a start time and a slot length, or by a start time and an end time.

In an embodiment, a downstream slot mapping partition is carried in at least one associated downstream slot at a front portion of a downstream superframe indicated by a downstream synchronization header or by default configuration information.

In an embodiment, the downstream synchronization header indicates a code type used in an associated downstream slot corresponding to a first FEC code block of a downstream superframe, and based on an FEC code type used by the first FEC code block of the downstream superframe, the value of the downstream synchronization header is determined, and a downstream slot mapping partition is carried in the first FEC code block.

In an embodiment, a downstream synchronization header indicates a code type used in slots corresponding to the entirety of a downstream superframe; and based on a code type used by the entirety of the downstream superframe, the value of the downstream synchronization header is determined.

In an embodiment, a downstream synchronization header indicates a code type used in slots corresponding to at least two FEC code blocks at a front portion of a downstream superframe; and based on the slots corresponding to the at least two FEC code blocks at the front portion of the downstream superframe and the used code type, the value of the downstream synchronization header is determined, and a downstream slot mapping partition is carried in each of the at least two FEC code blocks at the front portion of the downstream superframe.

In an embodiment, the code type indication information comprises at least two downstream synchronization headers, and each downstream synchronization header indicates an FEC code type used in an associated downstream slot in a downstream superframe; and based on an associated downstream slot in each downstream superframe and an FEC code type used by the associated downstream slot, the value of each downstream synchronization header is determined, and a downstream slot mapping partition is carried in the associated downstream slot in the each downstream superframe.

In an embodiment, default configuration information indicates a code type used in an associated downstream slot corresponding to a first FEC code block of a downstream superframe, and a downstream slot mapping partition is carried in the first FEC code block.

In an embodiment, default configuration information indicates a code type used in slots corresponding to at least two FEC code blocks at a front portion of a downstream superframe, and a downstream slot mapping partition is carried in each of the at least two FEC code blocks at the front portion of the downstream superframe.

The communication apparatus provided in the embodiment is configured to perform the communication method applied to a second communication node in the embodiment shown in FIG. 5 and has similar implementation principles and technical effects, which are not repeated here.

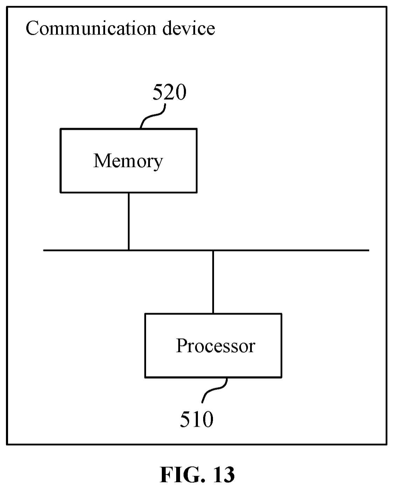

In an embodiment, FIG. 13 is a diagram illustrating the structure of a communication device according to an embodiment of the present application. As shown in FIG. 13, the device provided in the present application includes a processor 510 and a memory 520. One or more processors 510 may be included in the device. One processor 510 is shown as an example in FIG. 13. One or more memories 520 may be provided in the device. One memory 520 is shown as an example in FIG. 13. The processor 510 and memory 520 of the device may be connected by a bus or in other manners. The connection by a bus is used as an example in FIG. 13. In this embodiment, the device may be a first communication device.

The memory 520, as a computer-readable storage medium, may be configured to store software programs, computer-executable programs, and modules, such as program instructions/modules (for example, the decoder 310 in the communication apparatus applied to the first communication device) corresponding to the device in any embodiment of the present application. The memory 520 may include a program storage region and a data storage region. The program storage region may store an operating system and an application program required by at least one function. The data storage region may store data created according to the use of the device. Moreover, the memory 520 may include a high-speed random-access memory and may also include a non-volatile memory such as at least one magnetic disk memory, a flash memory, or another non-volatile solid-state memory. In some examples, the memory 520 may include memories that are remotely disposed relative to the processor 510, and these remote memories may be connected to the device via a network. Examples of the preceding network include but are not limited to, the Internet, an intranet, a local area network, a mobile communication network, and a combination thereof.

In a case where the communication device is a first communication device, the preceding device may be configured to execute the communication method applied to the first communication device in any one of the preceding embodiments and has corresponding functions and effects.

In the case where the communication device is a second communication device, the preceding device may be configured to execute the communication method applied to the second communication device in any one of the preceding embodiments and has corresponding functions and effects.

An embodiment of the present application also provides a storage medium containing computer-executable instructions, which, when executed by a computer processor, are used to perform a communication method applied to a first communication device. The communication method includes performing, based on code type indication information, FEC decoding on part or all of associated downstream slots using an FEC code type corresponding to the code type indication information, where the code type indication information is received from a second communication device and is used to indicate an FEC code type used in at least one of the associated downstream slots.

An embodiment of the present application also provides a storage medium containing computer-executable instructions, which, when executed by a computer processor, are used to perform a communication method applied to a second communication device. The communication method includes determining at least one FEC code type corresponding to at least one FEC code block in at least one associated slot; generating, based on part or all of the at least one associated slot and the at least one FEC code type, code type indication information, where the code type indication information is used to indicate an FEC code type used in at least one associated downstream slot; generating, in an associated slot among the at least one associated slot , an FEC code block using a respective FEC code type among the at least one FEC code type; and sending the code type indication information and the generated FEC code block to a first communication device.

It is to be understood by those skilled in the art that the term "user equipment" covers any suitable type of wireless user equipment, for example, a mobile phone, a portable data processing apparatus, a portable web browser, or a vehicle-mounted mobile station.

Generally speaking, various embodiments of the present application may be implemented in hardware or special-purpose circuits, software, logic, or any combination thereof. For example, some aspects may be implemented in hardware while other aspects may be implemented in firmware or software executable by a controller, a microprocessor, or another computing apparatus, though the present application is not limited thereto.

Embodiments of the present application may be implemented through the execution of computer program instructions by a data processor of a mobile apparatus, for example, implemented in a processor entity, by hardware, or by a combination of software and hardware. The computer program instructions may be assembly instructions, instruction set architecture (ISA) instructions, machine instructions, machine-related instructions, microcodes, firmware instructions, state setting data, or source or object codes written in any combination of one or more programming languages.

A block diagram of any logic flow among the drawings of the present application may represent program procedures, may represent interconnected logic circuits, modules, and functions, or may represent a combination of program procedures with logic circuits, modules, and functions. Computer programs may be stored in a memory. The memory may be of any type suitable for a local technical environment and may be implemented using any suitable data storage technology such as, but not limited to, a read-only memory (ROM), a random-access memory (RAM), or an optical memory device and system (a digital video disc (DVD), or a compact disc (CD)). The computer-readable medium may include a non-transitory storage medium. The data processor may be of any type suitable for a local technical environment, such as, but not limited to, a general-purpose computer, a special-purpose computer, a microprocessor, a digital signal processor (DSP), an application-specific integrated circuit (ASIC), a field-programmable gate array (FPGA), and a processor based on a multi-core processor architecture.

## Claims

1. A communication method, applied to a first communication device and comprising:
performing, based on code type indication information, forward error correction, FEC, decoding on part or all of associated downstream slots using an FEC code type corresponding to the code type indication information;
wherein the code type indication information is received from a second communication device and is used to indicate an FEC code type used in at least one of the associated downstream slots.

2. The communication method according to claim 1, further comprising:
performing FEC decoding, based on default configuration information, on part or all of the associated downstream slots using an FEC code type corresponding to the default configuration information;
wherein the default configuration information is used to indicate an FEC code type used in at least one of the associated downstream slots.

3. The communication method according to claim 1, wherein the code type indication information comprises at least one of: a downstream synchronization header or a downstream slot mapping partition.

4. The communication method according to claim 1, wherein the code type indication information comprises a downstream synchronization header, and the associated downstream slots of the downstream synchronization header comprise: slots corresponding to at least one FEC code block at a front portion of a downstream superframe or slots corresponding to an entirety of a downstream superframe; and
performing, based on the code type indication information, the FEC decoding on part or all of the associated downstream slots using the FEC code type corresponding to the code type indication information comprises:
decoding, based on the downstream synchronization header, one or more FEC code blocks whose code type matches the first communication device among the at least one FEC code block at the front portion of the downstream superframe, or decoding the entirety of the downstream superframe using a code type corresponding to the downstream synchronization header.

5. The communication method according to claim 2, wherein the associated downstream slots of the default configuration information are slots corresponding to at least one FEC code block at a front portion of a downstream superframe; and
performing, based on the default configuration information, the FEC decoding on part or all of the associated downstream slots using the FEC code type corresponding to the default configuration information comprises:
decoding, based on the default configuration information, one or more FEC code blocks whose code type matches the first communication device among the at least one FEC code block at the front portion of the downstream superframe.

6. The communication method according to claim 1, wherein the code type indication information comprises a downstream slot mapping partition, and the associated downstream slots of the downstream slot mapping partition are specified associated downstream slots in a downstream superframe; and
performing, based on the code type indication information, the FEC decoding on part or all of the associated downstream slots using the FEC code type corresponding to the code type indication information comprises:
decoding, based on the downstream slot mapping partition, an FEC code block in an associated downstream slot related to the first communication device using a code type corresponding to the downstream slot mapping partition.

7. The communication method according to claim 6, wherein the downstream slot mapping partition comprises at least one code type to slot entry, and the at least one code type to slot entry is used to indicate an FEC code type used in a specified associated downstream slot; and
decoding, based on the downstream slot mapping partition, the FEC code block in the associated downstream slot related to the first communication device using the code type corresponding to the downstream slot mapping partition comprises:
in response to an FEC code type indicated by the at least one code type to slot entry being consistent with an FEC code type supported by the first communication device, performing decoding, in an associated downstream slot corresponding to the at least one code type to slot entry, using a code type corresponding to the at least one code type to slot entry.

8. The communication method according to claim 7, wherein the downstream slot mapping partition further comprises at least one optical network unit, ONU, to slot entry, and the at least one ONU to slot entry is used to indicate a first communication device to which a specified associated downstream slot belongs; and
in response to the at least one ONU to slot entry belonging to the first communication device, decoding is performed in an associated downstream slot corresponding to a code type to slot entry associated with the at least one ONU to slot entry using a code type corresponding to the code type to slot entry, or decoding is performed in a slot corresponding to the at least one ONU to slot entry using a corresponding code type.

9. The communication method according to any one of claims 6 to 8, wherein the specified associated downstream slot is defined by a start time and a slot length, or by a start time and an end time.

10. The communication method according to claim 4, wherein the code type indication information is used to indicate an FEC code type used in slots corresponding to an entirety of a downstream superframe; and
performing, based on the code type indication information, the FEC decoding on part or all of the associated downstream slots using the FEC code type corresponding to the code type indication information comprises:
decoding, based on the code type indication information, the entirety of the downstream superframe using a code type corresponding to the code type indication information.

11. The communication method according to claim 4 or 5, wherein a downstream slot mapping partition is carried in at least one of the associated downstream slots indicated by the default configuration information or by the downstream synchronization header; and
the communication method further comprises:
parsing the downstream slot mapping partition after decoding an FEC code block that matches an FEC code type supported by the first communication device in the at least one of the associated downstream slots indicated by the default configuration information or by the downstream synchronization header.

12. The communication method according to claim 4 or 5, wherein the default configuration information or the code type indication information is used to indicate a code type in a slot corresponding to a first FEC code block of a downstream superframe; and
the communication method further comprises:
decoding, based on the default configuration information or the code type indication information, the first FEC code block, and parsing a downstream slot mapping partition.

13. The communication method according to claim 12, wherein in response to an FEC code type used by the first FEC code block being jointly indicated by the downstream synchronization header and the downstream slot mapping partition, an FEC code type indicated by the downstream synchronization header for the first FEC code block prevails.

14. The communication method according to claim 4 or 5, wherein the default configuration information or the code type indication information is used to indicate a code type in slots corresponding to at least two FEC code blocks at a front portion of a downstream superframe; and
the communication method further comprises:
performing FEC decoding, based on the default configuration information or the code type indication information, on an FEC code block corresponding to an FEC code type supported by the first communication device among the at least two FEC code blocks at the front portion of the downstream superframe, and parsing a downstream slot mapping partition.

15. The communication method according to claim 4, wherein the code type indication information comprises at least two downstream synchronization headers, and each of the at least two downstream synchronization headers has a corresponding associated downstream slot; and
the communication method further comprises:
identifying one of the at least two downstream synchronization headers, performing decoding in a corresponding associated downstream slot using a corresponding FEC code type, and parsing a downstream slot mapping partition.

16. The communication method according to any one of claims 11, 12, or 14 and 15, wherein the FEC code block or the associated downstream slot comprises a management information partition; wherein the management information partition at least comprises a downstream slot mapping partition or size information of a downstream slot mapping partition.

17. The communication method according to claim 16, wherein the size information of the downstream slot mapping partition is used to indicate a size of the downstream slot mapping partition or to indicate at least one of a number of code type to slot entries comprised in the downstream slot mapping partition or a number of ONU to slot entries comprised in the downstream slot mapping partition.

18. The communication method according to claim 16, wherein the downstream slot mapping partition comprises at least one of: at least one code type to slot entry or at least one ONU to slot entry, the at least one code type to slot entry indicates an FEC code type used in a corresponding slot, and the at least one ONU to slot entry indicates a first communication device to which the corresponding slot belongs.

19. A communication method, applied to a second communication device and comprising:
determining at least one FEC code type corresponding to at least one forward error correction, FEC, code block in at least one associated slot;
generating, based on part or all of the at least one associated slot and the at least one FEC code type, code type indication information, wherein the code type indication information is used to indicate an FEC code type used in at least one associated downstream slot;
generating, in an associated slot among the at least one associated slot , an FEC code block using a respective FEC code type among the at least one FEC code type; and
sending the code type indication information and the generated FEC code block to a first communication device.

20. The communication method according to claim 19, wherein an FEC code block in at least one associated downstream slot at a front portion of a downstream superframe and the corresponding FEC code type of the FEC code block are configured by default.

21. The communication method according to claim 19, wherein in response to the code type indication information indicating an FEC code type used in at least one associated downstream slot at a front portion of a downstream superframe or indicating an FEC code type used in all slots corresponding to a downstream superframe, the code type indication information comprises a downstream synchronization header; and
generating, based on part or all of the at least one associated slot and the at least one FEC code type, the code type indication information comprises:
determining, based on the at least one associated downstream slot at the front portion of the downstream superframe or the all slots corresponding to the downstream superframe and the corresponding FEC code type, a value of the downstream synchronization header.

22. The communication method according to claim 19, wherein in response to the code type indication information indicating an FEC code type used in a specified associated downstream slot of a downstream superframe, the code type indication information comprises a downstream slot mapping partition; and
generating, based on part or all of the at least one associated slot and the at least one FEC code type, the code type indication information comprises:
generating, based on the specified associated downstream slot of the downstream superframe and the corresponding FEC code type, the downstream slot mapping partition.

23. The communication method according to claim 22, wherein the downstream slot mapping partition comprises at least one code type to slot entry, and the at least one code type to slot entry is used to indicate an FEC code type used in a specified associated downstream slot; and
generating, based on the specified associated downstream slot of the downstream superframe and the corresponding FEC code type, the downstream slot mapping partition comprises:
generating, based on the specified associated downstream slot and the FEC code type used in the specified associated downstream slot, the at least one code type to slot entry.

24. The communication method according to claim 22, wherein the downstream slot mapping partition further comprises at least one optical network unit, ONU, to slot entry, and the at least one ONU to slot entry is used to indicate a first communication device to which the specified associated downstream slot belongs; and
the communication method further comprises:
generating, based on the specified associated downstream slot and the first communication device to which the specified associated downstream slot belongs, the at least one ONU to slot entry.

25. The communication method according to any one of claims 22 to 24, wherein the specified associated downstream slot is defined by a start time and a slot length, or by a start time and an end time.

26. The communication method according to claim 20 or 21, wherein a downstream slot mapping partition is carried in at least one associated downstream slot at a front portion of a downstream superframe indicated by a downstream synchronization header or by default configuration information.

27. The communication method according to claim 21, wherein the downstream synchronization header indicates a code type used in an associated downstream slot corresponding to a first FEC code block of a downstream superframe; and
the communication method further comprises:
determining, based on an FEC code type used by the first FEC code block of the downstream superframe, a value of the downstream synchronization header, and carrying a downstream slot mapping partition in the first FEC code block.

28. The communication method according to claim 19, wherein a downstream synchronization header indicates a code type used in slots corresponding to an entirety of a downstream superframe; and
the communication method further comprises:
determining, based on a code type used by the entirety of the downstream superframe, a value of the downstream synchronization header.

29. The communication method according to claim 19, wherein a downstream synchronization header indicates a code type used in slots corresponding to at least two FEC code blocks at a front portion of a downstream superframe; and
the communication method further comprises:
determining, based on the slots corresponding to the at least two FEC code blocks at the front portion of the downstream superframe and the used code type, a value of the downstream synchronization header, and carrying a downstream slot mapping partition in each of the at least two FEC code blocks at the front portion of the downstream superframe.

30. The communication method according to claim 21, wherein the code type indication information comprises at least two downstream synchronization headers, and each of the at least two downstream synchronization headers indicates an FEC code type used in an associated downstream slot in a downstream superframe; and
the communication method further comprises:
determining, based on an associated downstream slot in each downstream superframe and an FEC code type used by the associated downstream slot, a value of each of the at least two downstream synchronization headers, and carrying a downstream slot mapping partition in the associated downstream slot in the each downstream superframe.

31. The communication method according to claim 20, wherein default configuration information indicates a code type used in an associated downstream slot corresponding to a first FEC code block of a downstream superframe, and a downstream slot mapping partition is carried in the first FEC code block.

32. The communication method according to claim 20, wherein default configuration information indicates a code type used in slots corresponding to at least two FEC code blocks at a front portion of a downstream superframe, and a downstream slot mapping partition is carried in each of the at least two FEC code blocks at the front portion of the downstream superframe.

33. A communication device, comprising: a memory and at least one processor; wherein
the memory is configured to store at least one program; and
when executed by the at least one processor, the at least one program causes the at least one processor to implement the communication method according to any one of claims 1 to 18 or claims 19 to 32.

34. A storage medium storing a computer program that, when executed by a processor, implements the communication method according to any one of claims 1 to 18 or claims 19 to 32.
